# EUROPEAN PATENT APPLICATION

(11) **EP 4 852 628 A1**
(43) Date of publication of application: **09.12.2026**
(21) Application number: 26181731.6
(22) Date of filing: 28.05.2026
(51) Int. Cl.: H05K 5/00, H05K 5/06

(54) **POTTING BOAT ASSEMBLY**

(30) Priority: 06.06.2025 US 202519230723
(71) Applicant: Black & Decker, Inc., New Britain, CT 06053 (US)
(72) Inventor: MORENO PASTOR, Marcos Ariel, 67160 Guadalupe N.L (MX); CHILDERS, Justin T., Perry Hall, 21128 (US); LENNON, William J., Charlotte, 28262 (US); VALENTINE, Alastair G., Baltimore, 21212 (US)
(74) Representative: SBD IPAdmin

(57) **Abstract**

A potting boat assembly may include a metal potting boat and an electrically insulating retaining member for retaining a circuit board within the metal potting boat. The metal potting boat may include a base and at least one sidewall that extends from and surrounds the base. With the electrically insulating retaining member retaining the circuit board within the metal potting boat, the circuit board may be spaced apart from the base of the metal potting boat by the electrically insulating retaining member.

## Description

### BACKGROUND

This disclosure relates generally to a potting boat and, in some non-limiting embodiments or aspects, to a potting boat assembly including a metal potting boat and a plastic retaining member for retaining a circuit board within the metal potting boat.

Potting electronics is a process of encapsulating or embedding electronic components within a protective compound to shield them from various environmental factors like moisture, dust, and physical damage. This compound can be a gelatinous material like epoxy or a more solid compound, filling a mold or "pot" around the electronics. Potting is particularly useful for electronics used in harsh environments or applications where shock and vibration are a concern.

### SUMMARY

According to some non-limiting embodiments or aspects, provided is a potting boat assembly including: a metal potting boat including a base and at least one sidewall that extends from and surrounds the base; and an electrically insulating retaining member for retaining a circuit board within the metal potting boat, wherein, with the electrically insulating retaining member retaining the circuit board within the metal potting boat, the circuit board is spaced apart from the base of the metal potting boat by the electrically insulating retaining member.

In some non-limiting embodiments or aspects, the at least one sidewall extends between a first end that is connected to the base and a second end opposite the first end, wherein the second end of the at least one sidewall includes at least one connecting member, and wherein the electrically insulating retaining member includes a frame that extends within a plane of orientation and at least one complementary connecting member on the frame, wherein the at least one complementary connecting member is configured to engage with the at least one connecting member of the metal potting boat to secure the electrically insulating retaining member to the metal potting boat.

In some non-limiting embodiments or aspects, the at least one connecting member includes at least one tab that extends substantially perpendicularly from the second end of the at least one sidewall of the metal potting boat, and wherein the at least one complementary connecting member includes at least one resilient arm that extends from the frame substantially perpendicularly to the plane of orientation of the frame, wherein the at least one resilient arm extends between a first end that is connected to the frame and a second end opposite the first end, wherein the at least one resilient arm is configured to engage the at least one tab by deflecting to allow the second end of the at least one resilient arm to pass over the at least one tab and snap into engagement behind the at least one tab to secure the electrically insulating retaining member to the metal potting boat.

In some non-limiting embodiments or aspects, the at least one resilient arm includes at least one opening between the first end and the second end, wherein the at least one tab is received within the at least one opening when the second end of the at least one resilient arm is snapped into engagement behind the at least one tab to secure the electrically insulating retaining member to the metal potting boat.

In some non-limiting embodiments or aspects, the at least one tab extends from an outer surface of the at least one sidewall that is opposite an inner surface of the at least one sidewall that defines an interior of the metal potting boat with the base, wherein the frame has a closed shape that corresponds to a closed shape of the at least one sidewall, and wherein, with the at least one complementary connecting member engaged with the at least one connecting member of the metal potting boat to secure the electrically insulating retaining member to the metal potting boat, at least a portion of a lower surface of the frame is disposed on the second end of the at least one sidewall of the metal potting boat.

In some non-limiting embodiments or aspects, the at least one tab includes one or more first tabs that extend from the outer surface of the at least one sidewall at a first location of the closed shape of the at least one sidewall and one or more second tabs that extend from the outer surface of the at least one sidewall at a second location of the closed shape of the at least one sidewall opposite the first location of the closed shape of the at least one sidewall, and wherein the at least one resilient arm includes one or more first resilient arms that extend from the frame substantially perpendicularly to the plane of orientation of the frame at a first location of the closed shape of the frame and one or more second resilient arms that that extend from the frame substantially perpendicularly to the plane of orientation of the frame at a second location of the closed shape of the frame opposite the first location of the closed shape of the frame.

In some non-limiting embodiments or aspects, the electrically insulating retaining member includes a frame that extends within a plane of orientation and at least one supporting member that extends from the frame substantially perpendicularly to the plane of orientation of the frame, wherein the at least one supporting member extends between a first end that is connected to the frame and a second end opposite the first end, wherein the second end of the at least one supporting member includes a ledge that extends substantially perpendicularly from the at least one supporting member, and wherein, with the electrically insulating retaining member retaining the circuit board within the metal potting boat, the ledge supports the circuit board between the first and second ends of the at least one supporting member such that the circuit board is spaced apart from the base of the metal potting boat by the ledge of the at least one supporting member.

In some non-limiting embodiments or aspects, at least one edge of the circuit board includes at least one cutout that extends inward from the at least one edge of the circuit board, and wherein, with the electrically insulating retaining member retaining the circuit board within the metal potting boat, the at least supporting member extends through the at least one cutout in the circuit board.

In some non-limiting embodiments or aspects, the frame has a closed shape that corresponds to a closed shape of the at least one sidewall, and wherein the at least one supporting member includes one or more first supporting members that extend from the frame substantially perpendicularly to the plane of orientation of the frame at a first location of the closed shape of the frame and one or more second supporting members that that extend from the frame substantially perpendicularly to the plane of orientation of the frame at a second location of the closed shape of the frame opposite the first location of the closed shape of the frame.

In some non-limiting embodiments or aspects, with the electrically insulating retaining member retaining the circuit board within the metal potting boat, a potting material is disposed between the frame and the circuit board and between the circuit board and the base of the metal potting boat.

In some non-limiting embodiments or aspects, with the electrically insulating retaining member retaining the circuit board within the metal potting boat, at least one thermally conductive electrically insulating gap pad is disposed between and in contact with each of the circuit board and the base of the metal potting boat.

In some non-limiting embodiments or aspects, the electrically insulating retaining member further includes at least one wire trap that extends from the frame substantially perpendicularly to the plane of orientation of the frame in a direction opposite that of the at least one supporting member.

In some non-limiting embodiments or aspects, the at least one supporting member is heat staked to the base of the metal potting boat.

In some non-limiting embodiments or aspects, the circuit board includes a control module for supplying electric power from a DC power source to an electric motor.

In some non-limiting embodiments or aspects, the circuit board includes a first face and a second face opposite the first face, wherein, with the electrically insulating retaining member retaining the circuit board within the metal potting boat, the second face of the circuit board faces the base of the metal potting boat, and wherein the control module includes: a plurality of power switch devices including a plurality of high-side power switches and a plurality of low-side power switches mounted on the first face of the circuit board and configured as a multi-phase inverter circuit to provide a plurality of output phase terminals to the electric motor; one or more bus capacitors mounted on the first face of the circuit board; and a microcontroller mounted on the first face of the circuit board.

According to some non-limiting embodiments or aspects, provided is an electric power tool including: a tool housing; an electric motor disposed in the tool housing; and a potting boat assembly including: a metal potting boat including a base and at least one sidewall that extends from and surrounds the base; and an electrically insulating retaining member for retaining a circuit board within the metal potting boat, wherein, with the electrically insulating retaining member retaining the circuit board within the metal potting boat, the circuit board is spaced apart from the base of the metal potting boat by the electrically insulating retaining member, and wherein the circuit board includes a control module for supplying electric power from a DC power source to the electric motor.

Further non-limiting embodiments or aspects are set forth in the following numbered clauses:
Clause 1: A potting boat assembly comprising: a metal potting boat including a base and at least one sidewall that extends from and surrounds the base; and an electrically insulating retaining member for retaining a circuit board within the metal potting boat, wherein, with the electrically insulating retaining member retaining the circuit board within the metal potting boat, the circuit board is spaced apart from the base of the metal potting boat by the electrically insulating retaining member.

Clause 2: The potting boat assembly of clause 1, wherein the at least one sidewall extends between a first end that is connected to the base and a second end opposite the first end, wherein the second end of the at least one sidewall includes at least one connecting member, and wherein the electrically insulating retaining member includes a frame that extends within a plane of orientation and at least one complementary connecting member on the frame, wherein the at least one complementary connecting member is configured to engage with the at least one connecting member of the metal potting boat to secure the electrically insulating retaining member to the metal potting boat.

Clause 3: The potting boat assembly of clause 1 or clause 2, wherein the at least one connecting member includes at least one tab that extends substantially perpendicularly from the second end of the at least one sidewall of the metal potting boat, and wherein the at least one complementary connecting member includes at least one resilient arm that extends from the frame substantially perpendicularly to the plane of orientation of the frame, wherein the at least one resilient arm extends between a first end that is connected to the frame and a second end opposite the first end, wherein the at least one resilient arm is configured to engage the at least one tab by deflecting to allow the second end of the at least one resilient arm to pass over the at least one tab and snap into engagement behind the at least one tab to secure the electrically insulating retaining member to the metal potting boat.

Clause 4: The potting boat assembly of any of clauses 1-3, wherein the at least one resilient arm includes at least one opening between the first end and the second end, wherein the at least one tab is received within the at least one opening when the second end of the at least one resilient arm is snapped into engagement behind the at least one tab to secure the electrically insulating retaining member to the metal potting boat.

Clause 5: The potting boat assembly of any of clauses 1-4, wherein the at least one tab extends from an outer surface of the at least one sidewall that is opposite an inner surface of the at least one sidewall that defines an interior of the metal potting boat with the base, wherein the frame has a closed shape that corresponds to a closed shape of the at least one sidewall, and wherein, with the at least one complementary connecting member engaged with the at least one connecting member of the metal potting boat to secure the electrically insulating retaining member to the metal potting boat, at least a portion of a lower surface of the frame is disposed on the second end of the at least one sidewall of the metal potting boat.

Clause 6: The potting boat assembly of any of clauses 1-5, wherein the at least one tab includes one or more first tabs that extend from the outer surface of the at least one sidewall at a first location of the closed shape of the at least one sidewall and one or more second tabs that extend from the outer surface of the at least one sidewall at a second location of the closed shape of the at least one sidewall opposite the first location of the closed shape of the at least one sidewall, and wherein the at least one resilient arm includes one or more first resilient arms that extend from the frame substantially perpendicularly to the plane of orientation of the frame at a first location of the closed shape of the frame and one or more second resilient arms that that extend from the frame substantially perpendicularly to the plane of orientation of the frame at a second location of the closed shape of the frame opposite the first location of the closed shape of the frame.

Clause 7: The potting boat assembly of any of clauses 1-6, wherein the electrically insulating retaining member includes a frame that extends within a plane of orientation and at least one supporting member that extends from the frame substantially perpendicularly to the plane of orientation of the frame, wherein the at least one supporting member extends between a first end that is connected to the frame and a second end opposite the first end, wherein the second end of the at least one supporting member includes a ledge that extends substantially perpendicularly from the at least one supporting member, and wherein, with the electrically insulating retaining member retaining the circuit board within the metal potting boat, the ledge supports the circuit board between the first and second ends of the at least one supporting member such that the circuit board is spaced apart from the base of the metal potting boat by the ledge of the at least one supporting member.

Clause 8: The potting boat assembly of any of clauses 1-7, wherein at least one edge of the circuit board includes at least one cutout that extends inward from the at least one edge of the circuit board, and wherein, with the electrically insulating retaining member retaining the circuit board within the metal potting boat, the at least supporting member extends through the at least one cutout in the circuit board.

Clause 9: The potting boat assembly of any of clauses 1-8, wherein the frame has a closed shape that corresponds to a closed shape of the at least one sidewall, and wherein the at least one supporting member includes one or more first supporting members that extend from the frame substantially perpendicularly to the plane of orientation of the frame at a first location of the closed shape of the frame and one or more second supporting members that that extend from the frame substantially perpendicularly to the plane of orientation of the frame at a second location of the closed shape of the frame opposite the first location of the closed shape of the frame.

Clause 10: The potting boat assembly of any of clauses 1-9, wherein, with the electrically insulating retaining member retaining the circuit board within the metal potting boat, a potting material is disposed between the frame and the circuit board and between the circuit board and the base of the metal potting boat.

Clause 11: The potting boat assembly of any of clauses 1-10, wherein, with the electrically insulating retaining member retaining the circuit board within the metal potting boat, at least one thermally conductive electrically insulating gap pad is disposed between and in contact with each of the circuit board and the base of the metal potting boat.

Clause 12: The potting boat assembly of any of clauses 1-11, wherein the electrically insulating retaining member further includes at least one wire trap that extends from the frame substantially perpendicularly to the plane of orientation of the frame in a direction opposite that of the at least one supporting member.

Clause 13: The potting boat assembly of any of clauses 1-12, wherein the at least one supporting member is heat staked to the base of the metal potting boat.

Clause 14: The potting boat assembly of any of clauses 1-13, wherein the circuit board includes a control module for supplying electric power from a DC power source to an electric motor.

Clause 15: The potting boat assembly of any of clauses 1-14, wherein the circuit board includes a first face and a second face opposite the first face, wherein, with the electrically insulating retaining member retaining the circuit board within the metal potting boat, the second face of the circuit board faces the base of the metal potting boat, and wherein the control module includes: a plurality of power switch devices including a plurality of high-side power switches and a plurality of low-side power switches mounted on the first face of the circuit board and configured as a multi-phase inverter circuit to provide a plurality of output phase terminals to the electric motor; one or more bus capacitors mounted on the first face of the circuit board; and a microcontroller mounted on the first face of the circuit board.

Clause 16: An electric power tool comprising: a tool housing; an electric motor disposed in the tool housing; and the potting boat assembly of any of clauses 1-15 disposed in the tool housing, wherein the circuit board includes a control module for supplying electric power from a DC power source to the electric motor.

These and other features and characteristics of the present disclosure, as well as the methods of operation and functions of the related elements of structures and the combination of parts and economies of manufacture, will become more apparent upon consideration of the following description and the appended claims with reference to the accompanying drawings, all of which form a part of this specification, wherein like reference numerals designate corresponding parts in the various figures. It is to be expressly understood, however, that the drawings are for the purpose of illustration and description only and are not intended as a definition of the limits of the disclosed subject matter.

### BRIEF DESCRIPTION OF THE DRAWINGS

Additional advantages and details are explained in greater detail below with reference to the non-limiting, exemplary embodiments that are illustrated in the accompanying schematic figures, in which:
FIG. 1A depicts a side view of a power tool with a housing half removed, according to some non-limiting embodiments or aspects;
FIG. 1B depicts an enlarged side view of a portion of the power tool of FIG. 1A with the housing half removed, according to some non-limiting embodiments or aspects;
FIG. 2 depicts a block circuit diagram of a control module mounted in connection with a stator assembly of a corresponding electric motor, according to some non-limiting embodiments or aspects;
FIG. 3 depicts a circuit diagram of a power switch circuit of a control module, according to some non-limiting embodiments or aspects;
FIGS. 4A-4D depict upper perspective views of a potting boat assembly, according to some non-limiting embodiments or aspects;
FIGS. 5A and 5B depict lower perspective views of a potting boat assembly, according to some non-limiting embodiments or aspects;
FIGS. 6A and 6B depict exploded upper perspective views of a potting boat assembly, according to some non-limiting embodiments or aspects;
FIGS. 7A and 7B depict partially exploded upper perspective views of a potting boat assembly, according to some non-limiting embodiments or aspects;
FIGS. 8A and 8B depict an exploded lower perspective view and a partially exploded lower perspective view, respectively, of a potting boat assembly, according to some non-limiting embodiments or aspects; and
FIG. 9 depicts a cross-sectional view of a potting boat assembly, according to some non-limiting embodiments or aspects.

### DETAILED DESCRIPTION

For purposes of the description hereinafter, the terms "end," "upper," "lower," "right," "left," "vertical," "horizontal," "top," "bottom," "lateral," "longitudinal," and derivatives thereof shall relate to the embodiments as they are oriented in the drawing figures. However, it is to be understood that the embodiments may assume various alternative variations and step sequences, except where expressly specified to the contrary. It is also to be understood that the specific devices and processes illustrated in the attached drawings, and described in the following specification, are simply exemplary embodiments or aspects of the disclosed subject matter. Hence, specific dimensions and other physical characteristics related to the embodiments or aspects disclosed herein are not to be considered as limiting.

It is to be understood that the present disclosure may assume various alternative variations and step sequences, except where expressly specified to the contrary. It is also to be understood that the specific devices and processes illustrated in the attached drawings, and described in the following specification, are simply exemplary and non-limiting embodiments or aspects. Hence, specific dimensions and other physical characteristics related to the embodiments or aspects disclosed herein are not to be considered as limiting.

No aspect, component, element, structure, act, step, function, instruction, and/or the like used herein should be construed as critical or essential unless explicitly described as such. Also, as used herein, the articles "a" and "an" are intended to include one or more items and may be used interchangeably with "one or more" and "at least one." Furthermore, as used herein, the term "set" is intended to include one or more items (e.g., related items, unrelated items, a combination of related and unrelated items, and/or the like) and may be used interchangeably with "one or more" or "at least one." Where only one item is intended, the term "one" or similar language is used. Also, as used herein, the terms "has," "have," "having," or the like are intended to be open-ended terms. Further, the phrase "based on" is intended to mean "based at least partially on" unless explicitly stated otherwise. In addition, reference to an action being "based on" a condition may refer to the action being "in response to" the condition. For example, the phrases "based on" and "in response to" may, in some non-limiting embodiments or aspects, refer to a condition for automatically triggering an action (e.g., a specific operation of an electronic device, such as a computing device, a processor, and/or the like).

Some of the techniques described herein may be implemented by one or more computer programs executed by one or more processors residing, for example on a power tool or power equipment. The computer programs may include processor-executable instructions that are stored on a non-transitory tangible computer readable medium. The computer programs may also include stored data. Non-limiting examples of the non-transitory tangible computer readable medium are nonvolatile memory, magnetic storage, and optical storage.

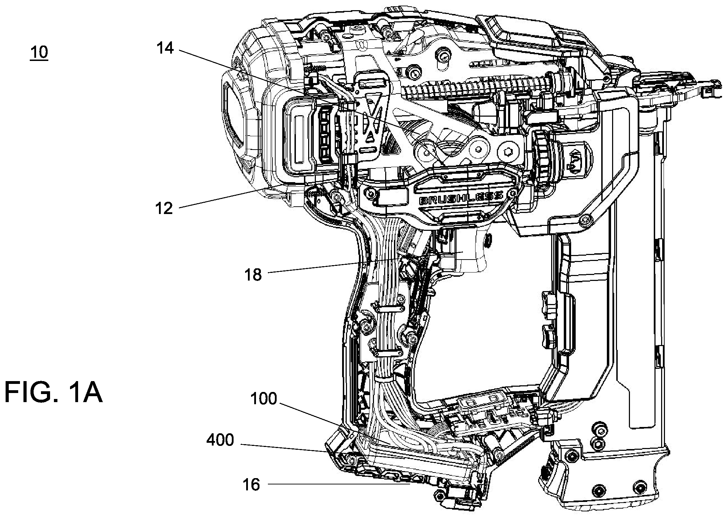

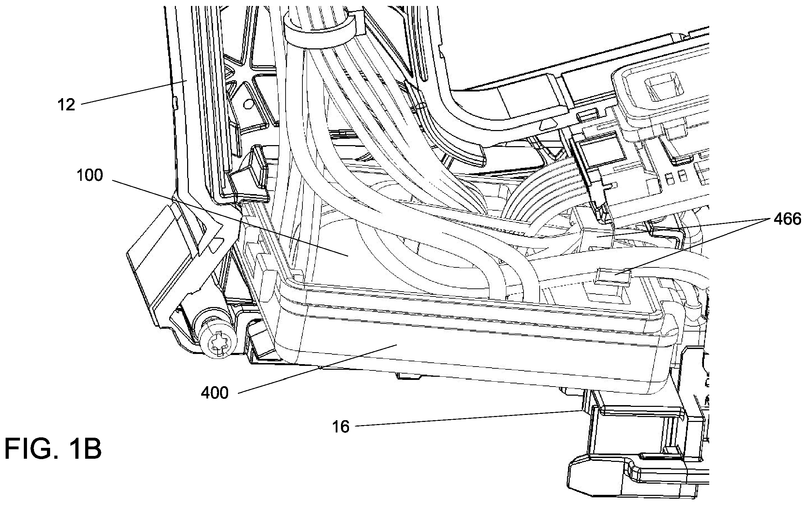

FIG. 1A depicts a side view of power tool 10 (e.g., a nailer, etc.) with tool housing 12 half removed, according to some non-limiting embodiments or aspects, and FIG. 1B depicts an enlarged side view of a portion of the power tool of FIG. 1A with housing 12 half removed, according to some non-limiting embodiments or aspects. As shown in FIGS. 1A and 1B, power tool 10 may include tool housing 12, electric motor 14 (e.g., a high-power electric motor, etc.) disposed in tool housing 12, battery receptacle or box 16, trigger mechanism 18, control module 100 disposed in tool housing 12, and/or potting boat assembly 400 disposed in tool housing 12. Electric motor 14 may include a brushed DC motor, a brushless DC motor, such as an electric brushless direct-current (BLDC) drive motor, and/or the like.

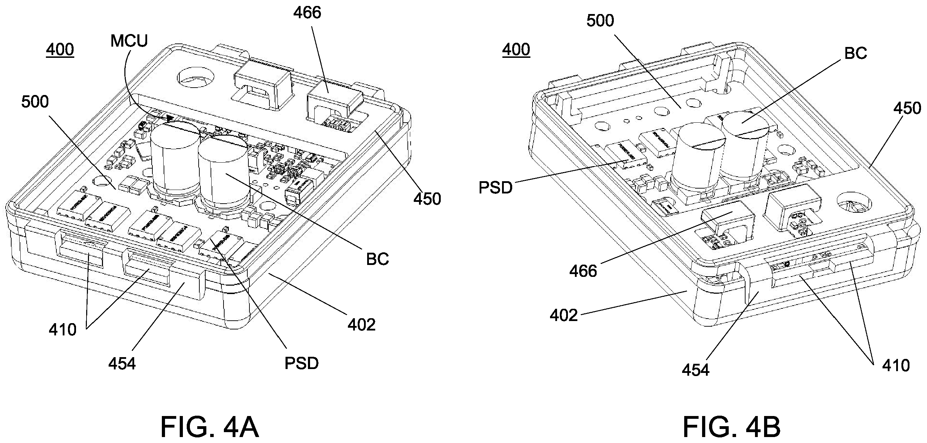

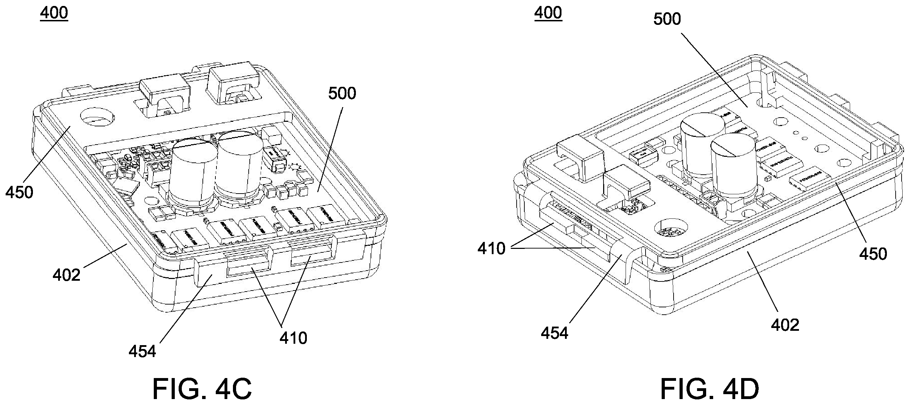

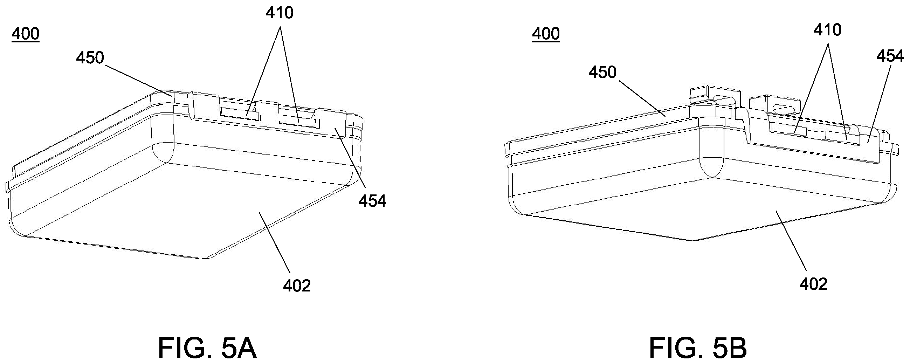

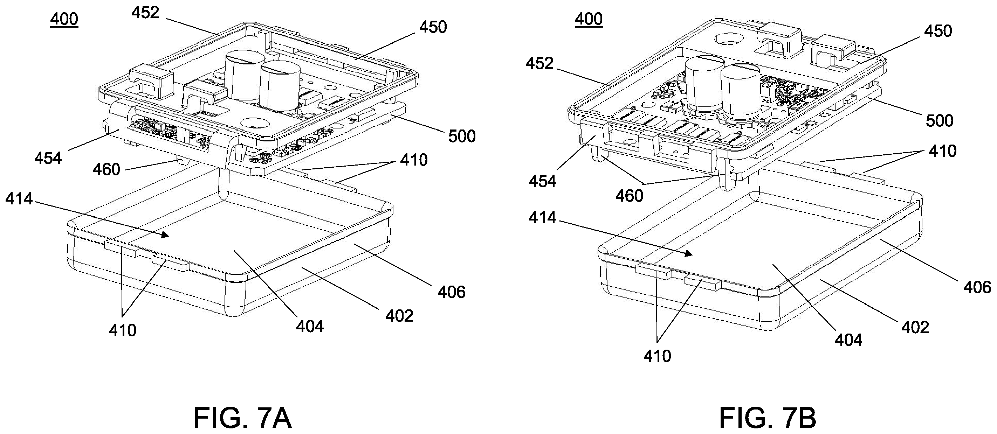

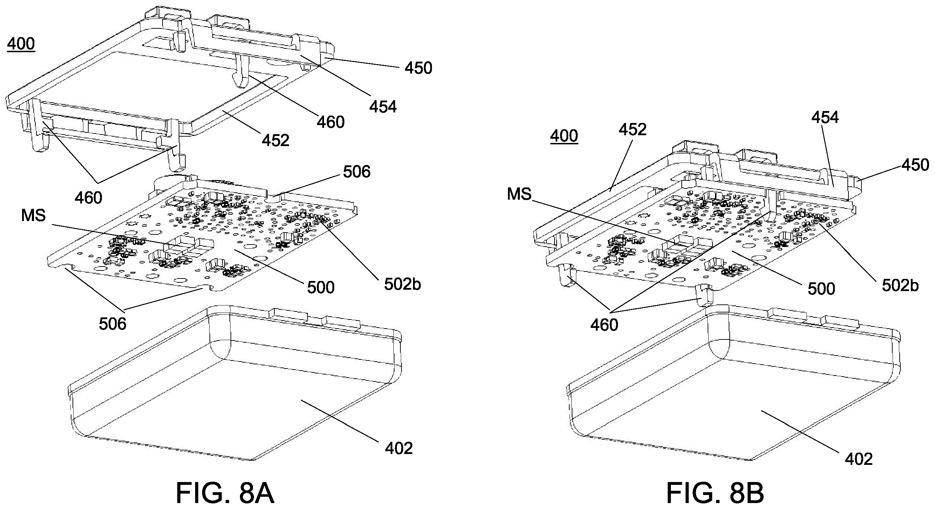

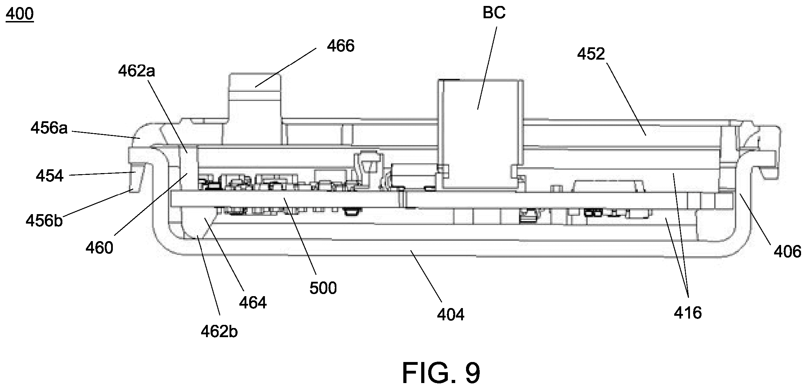

Control module 100 may include a microcontroller, a microprocessor, or other programmable semiconductor chip and power switching components for controlling a commutation of electric motor 14. Alternatively, control module 100 may include an Application Specific Integrated Circuit (ASIC) and the power switching components. Control module 16 may be coupled to a battery pack when the battery pack is received within battery receptacle 16. Control module 100 may control or regulate a supply of electric power from the battery pack to electric motor 14 received within battery receptacle 16 to electric motor 14 for controlling a commutation of electric motor 14, for example, based on a logic signal from an input unit (e.g., trigger mechanism 18, etc.) electrically coupled to control module 100. Control module 100 (e.g., a circuit board including components of control module 100, etc.) may be disposed or received in potting boat assembly 400 as described in more detail herein with respect to FIGS. 4A-9.

Some non-limiting embodiments or aspects of the present disclosure are focused on the structure and features of potting boat assembly 400. Details of the components and operation of an exemplary power tool, such as a grinder, including a brushless direct-current motor utilized therein, may be found in United States Patent Application Publication No. 2022/0247257 and United States Patent Application Publication No. 2017/0110945, which are incorporated herein by reference in their entireties.

It is noted herein that while some non-limiting embodiments or aspects of the present disclosure are described with reference to a nailer, potting boat assembly 400 and associated components discussed herein can be used with any system for controlling a supply of electric power from a power source to a power consuming component, such as any brushless motor control application, and particularly in any power tool or motorized product application. For example, potting boat assembly 100 may be used with a brushless motor in a drill, impact driver, grinder, saw, sander, tapper, nailer, powered cart and wheel barrow, lawn mower, lawn and garden tractor, lawn trimmer, lawn edger, lawn and leaf blower or sweeper, hedge trimmer, pruner, lopper, chainsaw, rake, pole saw, tiller, cultivator, aerator, log splitter, post hole digger, trencher, stump grinder, snow thrower (or any other snow or ice cleaning or clearing implement), lawn, wood and leaf shredder and chipper, lawn and/or leaf vacuum, pressure washer, lawn equipment, garden equipment, driveway sprayer and spreader, sports field marking equipment, or any other power tool or power consuming equipment.

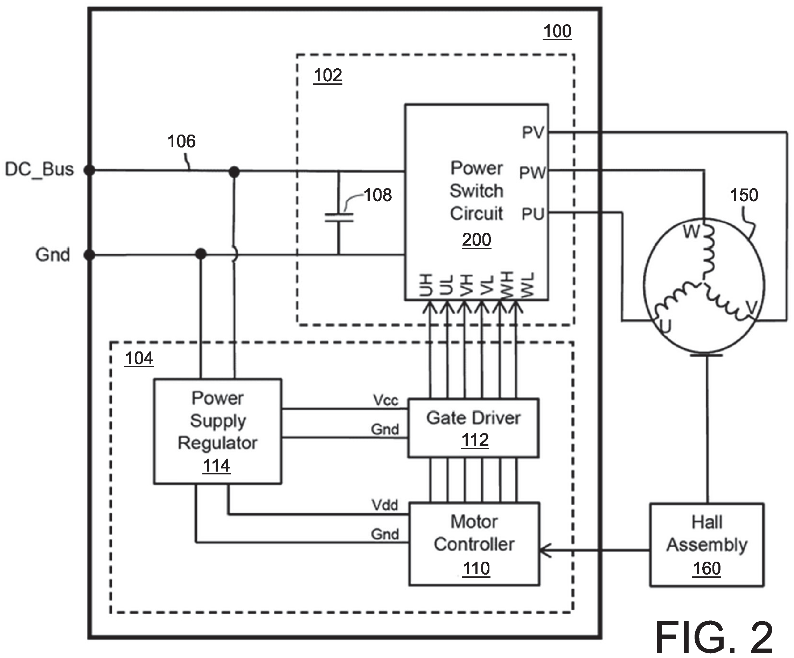

FIG. 2 depicts a block circuit diagram of control module 100 mounted in connection with stator assembly 150 of electric motor 14, according to some non-limiting embodiments or aspects. Control module 100 may include power unit 102 and/or control unit 104.

Power unit 102 may include power switch circuit 200 coupled between DC bus line 106 and stator assembly 150 to drive electric motor 14. In some implementations, power switch circuit 200 may include a three-phase inverter bridge driver circuit including controllable semiconductor power switches (e.g. FETs, BJTs, IGBTs, GaN FETs, GAN HEMTs, etc.). In some implementations, power unit 102 may include DC bus capacitor 108 provided across DC bus line 106 and Gnd.

Control unit 104 may include motor controller 110, gate driver 112, and/or power supply regulator 114. Motor controller 110 may include a programmable device arranged to control a switching operation of power switches in power switch circuit 200. In some implementations, motor controller 110 may receive rotor rotational position signals from Hall assembly 160 or other types of positional sensors that interact with a rotor. It should also be noted, however, that motor controller 110 may be configured to calculate or detect rotational positional information relating to the motor rotor using a sensorless control technique, such as field-oriented control. In some implementations, motor controller 110 may receive a variable-speed signal that relates to a desired speed of electric motor 14 (e.g., a desired speed set by an operator, etc.). Based on the rotor rotational position signals from Hall assembly 160 or the other types of positional sensors and the variable-speed signal, motor controller 110 may control a pulse-width modulation (PWM) control of drive signals UH, VH, WH, UL, VL, and WL through the gate driver 112, which may provide a voltage level needed to drive gates of semiconductor power switches within power switch circuit 200 in order to control a PWM switching operation of power switch circuit 200.

Power supply regulator 114 may include one or more voltage regulators to step down power source 16 to a voltage level compatible for operating motor controller 110 and/or gate driver 112. In some implementations, power supply regulator 114 may include a buck converter and/or a linear regulator to reduce the power voltage of DC bus line 106 to, for example, 15V for powering gate driver 112 and down to, for example, 3.2V for powering motor controller 110.

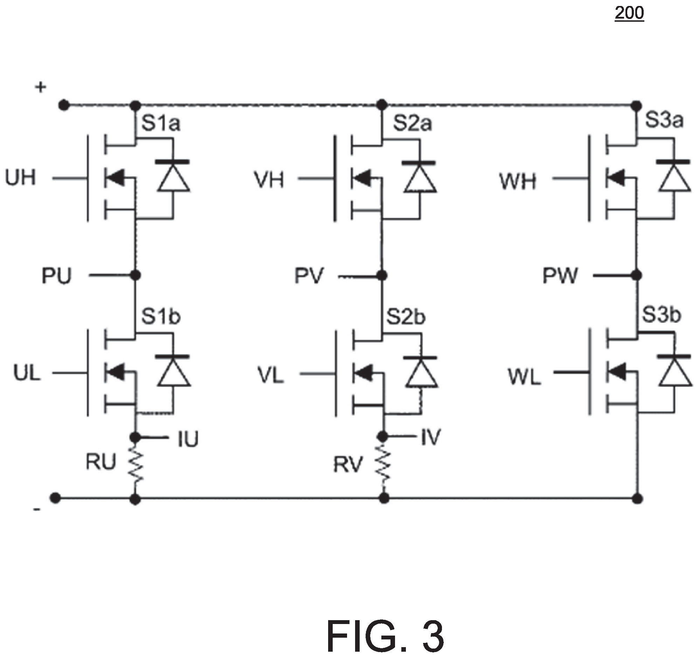

FIG. 3 depicts a circuit diagram of power switch circuit 200 of control module 100, according to some non-limiting embodiments or aspects. Power switch circuit 200 may have a three-phase inverter bridge circuit. For example, power switch circuit 200 may correspond to a three-phase motor including three sets of windings pairs, with each pair wound on two opposite stator teeth. It should be understood that the inverter bridge circuit may include more phases corresponding to the number of phases of the motor. The power switches may be, for example, MOSFETs, or FETs for short, as shown in FIG. 3, through it must be understood that IGBTs, BJTs) Gan FETs, GaN HEMTs, or similar semiconductor switches may be alternatively utilized. In this example, the three-phase inverter bridge circuit includes three high-side FETs S1a, S2a, and S3a and three low-side FETs S1b, S2b, and S3b. The gates of the high-side FETs S1a, S2a, and S3a may be driven via drive signals UH, VH, and WH, and the gates of the low-side FETs S1b, S2b, and S3b may be driven via drive signals UL, VL, and WL. In some implementations, the drains of the high-side FETs S1a, S2a, and S3a may be coupled to the sources of the low-side FETs S1b, S2b, and S3b to output power signals PU, PV, and PW for driving the electric motor 14.

However, some non-limiting embodiments or aspects of the present disclosure are not limited thereto and twelve power switches (e.g., three pairs of high-side FETs S1a, S2a, and S3a and the three pairs of low-side FETs S1b, S2b, and S3b, etc.) may be utilized for power switch circuit 200, for example, as disclosed in United States Patent Application Publication No. 2024/0072616, which is incorporated herein by reference in its entirety. Alternatively, more than the two power switches may be used for each pair of the three pairs of high-side power switches and the three pairs of low-side power switches of power switch circuit 200 for higher power applications, for example. While this disclosure makes references to FETs, it should be understood that any such power switches may be alternatively used.

The gates of the power switches may be controlled by a microcontroller in control unit 104 coupled to gate driver 112. For example, control unit 104 may construct a sinusoidal voltage waveform for each phase of the motor by controlling a Space-Vector Pulse-Width Modulated (SVPWM) of the high-side and low-side FETs in accordance with the desired Id and Iq currents, as discussed later in detail. The SVPWM technique is a modulation scheme used to determine duty cycles of the PWM signals for high-side and low-side FETs in order to apply a vector voltage as a combination of three phase voltage signals to the motor. The PWM duty cycles of the FETs are varied within each phase in a way to construct phase voltages that are substantially sinusoidal in waveform and that, when applied to the motor sequentially, cause rotation of the motor in the desired direction and speed.

Using a feedback loop of the phase currents of the motor, control unit 104 may calculate the rotor position for use in SVPWM commutation control, as described in United States Patent No 11,469,697, which is incorporated herein by reference in its entirety. In this manner, electric motor 14 may be controlled and commutated without a need for position sensors, such as Hall assembly 160, thus reducing motor size and manufacturing cost.

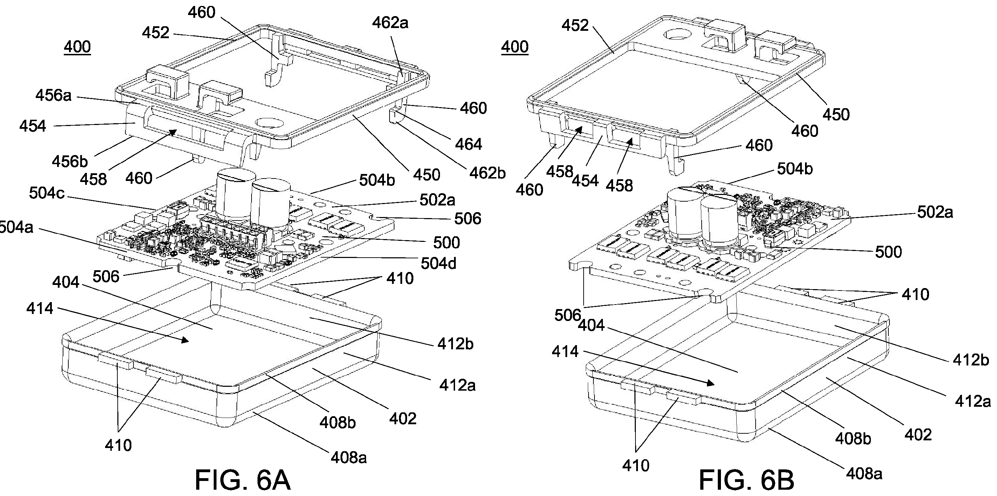

To measure the phase currents of the stator, a series of shunt resistors may be provided along the current paths of the motor phases. As shown in FIG. 3, shunt resistors RU and RV are disposed in series with the corresponding low-side FETs, between the low-side FETs S1b and S2b and the ground terminal of power source 16. By measuring the voltage across these resistors, motor controller 110 may calculate the current passing through corresponding phases of the motor. In FIG. 6, the motor phase currents are represented by signals IU and IV for simplicity, though it should be understood that motor controller 110 may measure the voltage across each shunt resistor RU and RV to calculate the phase current. For example, in FIG. 6, motor controller 110 may receive only one node of RU and RV, since the other node of RU and RV is commonly coupled to the negative terminal of power source 16.

In these embodiments, motor controller 110 may only measure two of the phase currents IU and IV and calculate the third phase current IW using Kirchhoff's current law, IU+IV+IW=0. It should be understood that motor controller 110 may alternatively receive other combinations of two signal currents (e.g., IU and IW, or IV and IW). Alternatively, motor controller 110 may receive all three current signals and rely on Kirchhoff s current law as means of redundant current measurement to ensure against circuit component failure.

In power tool applications, particularly cordless tools where size is limited, addition of the two or three shunt resistors described above to the power tool circuit presents challenges. In some implementations, instead of the three additional shunt resistors, the resistive characteristics of the FETs may be taken advantage of to measure the motor current.

In some implementations, no dedicated shunt resistors are provided, and the low-side FETs themselves may be used for current measurement. The FETs have a predominantly resistive conduction mode when in the ON-state, which can be of the order of a few milliohms or less. Thus, the resistive conduction of the low-side FETs may be leveraged in place of shunt resistors, allowing motor controller 110 to calculate the current on each motor phase. By way of example, instead of measuring current using shunt resistors RU and RV and via signals IU and IV, motor controller 110 may measure current passing through low-side FETs S1b, S2b, and S3b via signals PU, PV and PW, as described in United States Patent No. 11,469,697, which is incorporated herein by reference in its entirety.

Some non-limiting embodiments or aspects of the mechanical construction of potting boat assembly 400 are described herein with reference to FIGS. 4A-9.

As shown in FIGS. 4A-9, potting boat assembly may include metal potting boat 402 and/or electrically insulating retaining member 450.

Metal potting boat 402 may include base 404 and sidewall 406 that extends from and surrounds base 404. Sidewall 406 may between first end 408a that is connected to base 404 and second end 408b opposite first end 408a. Second end 408b of sidewall 406 may include at least one connecting member. For example, the at least one connecting member may include at least one tab 410 that extends substantially perpendicularly from second end 408b of sidewall 406 of metal potting boat 402. As an example, the at least one tab 410 may extend from outer surface 412a of sidewall 406 that is opposite inner surface 412b of sidewall 406 that defines interior 414 of metal potting boat 402 with base 404.

Sidewall 406 may have a closed shape. For example, sidewall 406 may have a closed shape that corresponds to a shape of circuit board 400. As an example, the closed shape of sidewall 406 may be configured to receive circuit board 500 within interior 414 of metal potting boat 402 with circuit board 500 spaced apart from sidewall 406. As an example, circuit board 500 may have a rectangular or rounded rectangular shape, and the closed shape of sidewall 406 may have a corresponding rectangular or rounded rectangular shape larger than that of circuit board 500 such that circuit board 500 may be received within interior 414 of metal potting boat 402 without contacting sidewall 406 of metal potting boat 402. In such an example, circuit board 500 may include first face 502a and second face 502b opposite first face 502a, and with circuit board 500 received within interior 414 of metal potting boat 402, second face 502b of circuit board 500 may face base 404 of metal potting boat 402, and potting material 416 may be disposed between circuit board 500 (e.g., between edges 504a-d of circuit board 500, etc.) and sidewall 406, between second face 502b of circuit board 500 and base 404 of metal potting boat 402, and/or on first face 502a of circuit board 500.

The at least one tab 410 may include one or more first tabs that extend from outer surface 412a of sidewall 406 at a first location of the closed shape of sidewall 406 and one or more second tabs that extend from outer surface 412a of sidewall 406 at a second location of the closed shape of sidewall 406 opposite the first location of the closed shape of sidewall 406. For example, sidewall 406 may include a first sidewall opposite a second sidewall, a third sidewall that connect first ends of the first sidewall and the second sidewall, and a fourth sidewall that connects second ends of the first sidewall and the second sidewall to form the closed shape (e.g., the rectangular or rounded rectangular shape, etc.). As an example, the at least one tab 410 may include the one or more first tabs that extend from outer surface 412a of the first sidewall and the one or more second tabs that extend from outer surface 412a of the second sidewall opposite the first sidewall. In such an example, the one or more first tabs may include a first pair of tabs that are spaced apart from each other along outer surface 412a of the first sidewall and a second pair of tabs that are spaced apart from each other along outer surface 412a of the second sidewall opposite the first sidewall.

Electrically insulating retaining member 450 may be configured to retain circuit board 500 within metal potting boat 402. For example, with electrically insulating retaining member 450 retaining circuit board 500 within metal potting boat 402, circuit board 500 (e.g., second face 502b of circuit board 500, etc.) may be spaced apart from base 404 of metal potting boat 402 by electrically insulating retaining member 450.

Electrically insulating retaining member 450 may include frame 452 that extends within a plane of orientation and at least one complementary connecting member on frame 452. The at least one complementary connecting member may be configured to engage with the at least one connecting member of metal potting boat 402 to secure electrically insulating retaining member 450 to metal potting boat 402. For example, the at least one complementary connecting member may include at least one resilient arm 454 that extends from frame 452 substantially perpendicularly to the plane of orientation of frame 452. The at least one resilient arm 454 may extend between first end 456a that is connected to frame 452 and second end 456b opposite first end 456a, and the at least one resilient arm 454 may be configured to engage the at least one tab 410 by deflecting to allow the second end 456b of the at least one resilient arm 454 to pass over the at least one tab 410 and snap into engagement behind the at least one tab 410 to secure electrically insulating retaining member 450 to metal potting boat 402. In such an example, the at least one resilient arm 454 may include at least one opening 458 between first end 456a and second end 456b, and the at least one tab 410 may be received within the at least one opening 458 when second end 456b of the at least one resilient arm 454 is snapped into engagement behind the at least one tab 410 to secure electrically insulating retaining member 450 to metal potting boat 452.

Frame 452 may have a closed shape that corresponds to the closed shape of sidewall 456. For example, with the at least one complementary connecting member engaged with the at least one connecting member of metal potting boat 402 to secure electrically insulating retaining member 450 to metal potting boat 450, at least a portion of a lower surface of frame 450 may be disposed on second end 408b of sidewall 406 of metal potting boat 402. As an example, frame 452 may have a rectangular or rounded rectangular shape.

The at least one resilient arm 454 may include one or more first resilient arms that extend from frame 452 substantially perpendicularly to the plane of orientation of frame 452 at a first location of the closed shape of frame 452 and one or more second resilient arms that that extend from frame 452 substantially perpendicularly to the plane of orientation of frame 452 at a second location of the closed shape of frame 452 opposite the first location of the closed shape of frame 452. For example, frame 452 may include a first side opposite a second side, a third side that connect first ends of the first side and the second side, and a fourth side that connects second ends of the first side and the second side to form the closed shape (e.g., the rectangular or rounded rectangular shape, etc.). As an example, the at least one resilient arm 454 may include the one or more first resilient arms that extend from the first side of frame 452 and the one or more second resilient arms that extend from the second side of frame 452 opposite the first side. As an example, the at least one opening 458 of the one or more first resilient arms and/or the one or more second resilient arms may include a single, continuous opening configured to receive each of the first pair of tabs or each of the second pair of tabs or a pair of openings spaced apart from each other by a portion of the resilient arm extending therebetween and configured to respectively receive a first tab and a second tab of the first pair of tabs or the second pair of tabs. In such an example, the one or more first resilient arms that extend from the first side of frame 452 may be configured to engage the first pair of tabs by deflecting to allow second end 456b thereof to pass over the first pair of tabs and snap into engagement behind the first pair of tabs with the first pair of tabs received in a single, continuous opening, and the one or more second resilient arms that extend from the second side of frame 452 opposite the first side may be configured to engage the second pair of tabs by deflecting to allow second end 456b thereof to pass over the second pair of tabs and snap into engagement behind the second pair of tabs with the second pair of tabs respectively received in a pair of openings spaced apart from each other by a portion of the resilient arm extending therebetween.

Although a complementary connection between metal potting boat 402 and electrically insulating retaining member 450 is described herein primarily with respect to a tab and a resilient arm connection (e.g., a snap tab connection, etc.), non-limiting embodiment or aspects of the present disclosure are not limited thereto, and the complementary connection between metal potting boat 402 and electrically insulating retaining member 450 may be formed by various other types of connections, such as other types of snap-fit connection including cantilever, annular, and/or torsional snap-fits, snap fasteners, and/or spring clips, and/or other types of mechanical connections.

Electrically insulating retaining member 450 may include a at least one supporting member 460 that extends from frame 4522 substantially perpendicularly to the plane of orientation of frame 452. For example, the at least one supporting member 460 may extend between first end 462a that is connected to frame 450 and second end 462b opposite first end 462a, and second end 462b of the at least one supporting member 460 may include ledge 464 that extends substantially perpendicularly from the at least one supporting member 460. As an example, with electrically insulating retaining member 450 retaining circuit board 500 within metal potting boat 402, the at least one supporting member 460 may extend within interior 414 of metal potting boat 402 and ledge 464 may support circuit board 500 between first and second ends 452a, 452b of the at least one supporting member 460 such that circuit board 500 is spaced apart from base 404 of metal potting boat 502 by ledge 464 of the at least one supporting member 460. In such an example, at least one edge of circuit board 500 (e.g., edges 504a and 504b, etc.) may include at least one cutout 506 that extends inward from the at least one edge of circuit board 500, and, with electrically insulating retaining member 450 retaining circuit board 500 within metal potting boat 402, the at least supporting member 460 may extend through the at least one cutout 506 in circuit board 500.

The at least one supporting member 460 may include one or more first supporting members that extend from frame 452 substantially perpendicularly to the plane of orientation of frame 452 at a first location of the closed shape of frame 452 and one or more second supporting members that that extend from frame 452 substantially perpendicularly to the plane of orientation of frame 452 at a second location of the closed shape of frame 452 opposite the first location of the closed shape of frame 452. For example, the at least one supporting member 460 may include the one or more first supporting members (e.g., a single supporting member, etc.) that extend from the first side of frame 452 and the one or more second supporting members (e.g., a pair of supporting members, etc.) that extend from the second side of frame 452 opposite the first side, and circuit board 500 may be received between the one or more first supporting members and the one or more second supporting members and rest on ledges 464 thereof that support circuit board 500 between first and second ends 452a, 452b of the supporting members and space circuit board 500 apart from base 404 of metal potting boat 402. In such an example, the supporting members may be flexible or resilient to enable the supporting members to be temporarily flexed away from each other to provide a larger space for placement of circuit board 500 therebetween.

The at least one supporting member 460 may contact or rest on base 404 of metal potting boat 402 or the at least one supporting member 460 may be spaced apart from base 404 of metal potting boat 402. In some implementations, the at least one supporting member 460 may be heat staked to base 404 of metal potting boat 402.

Electrically insulating retaining member 450 may include at least one wire trap 466 that extends from frame 452 substantially perpendicularly to the plane of orientation of frame 452 in a direction opposite that of the at least one supporting member 460. For example, as shown in FIG. 1B, the at least one wire trap 466 may secure one or more internal wires within tool housing 12 to potting boat assembly 400 for improved cable management and/or stability of the wires or potting boat assembly 400 within tool housing 12.

With electrically insulating retaining member 450 retaining circuit board 500 within metal potting boat 402, potting material 416 may be disposed between frame 452 and circuit board 500, between circuit board 500 and base 404 of metal potting boat 402, and/or between edges 506a-d of circuit board 500 and sidewall 406 of metal potting boat 402. In some implementations, with electrically insulating retaining member 450 retaining circuit board 500 within metal potting boat 402, at least one thermally conductive electrically insulating gap pad (not shown) may be disposed between and in contact with each of circuit board 500 and base 404 of metal potting boat 402. For example, the at least one thermally conductive electrically insulating gap pad may interface with metal slugs MS that have different electrical potentials on second face 502b of circuit board 500.

Circuit board 500 may include control module 100 for supplying electric power from a DC power source (e.g., from a battery pack received within battery receptacle 16, etc.) to an electric motor (e.g., electric motor 14, etc.). For example, circuit board 500 (e.g., components of control module 100 implemented on circuit board 500, etc.) may include a plurality of power switch devices PSD including a plurality of high-side power switches and a plurality of low-side power switches mounted on first face 502a of circuit board 500 and configured as a multi-phase inverter circuit to provide a plurality of output phase terminals to electric motor 14, one or more bus capacitors BC mounted on first face 502a of circuit board 500, and/or microcontroller MCU mounted on first face 502a of circuit board 500. As an example, potting boat assembly 400 may be disposed or received in tool housing 12 of power tool 10. In some implementations, as shown in FIGS. 1A and 1B, potting boat assembly 400 may be disposed within tool housing 12 proximate battery receptacle 16. For example, potting boat assembly 400 may be captured by a clamshell structure of tool housing 12 and forms a partition surface that separates battery receptacle 16 from an internal structure of tool housing 12. An example of this arrangement can be found in U.S. Patent Application Publication No. 2024/0363945A1, which is incorporated herein by reference in its entirety.

Although embodiments have been described in detail for the purpose of illustration, it is to be understood that such detail is solely for that purpose and that the disclosure is not limited to the disclosed embodiments or aspects, but, on the contrary, is intended to cover modifications and equivalent arrangements that are within the spirit and scope of the appended claims. For example, it is to be understood that the present disclosure contemplates that, to the extent possible, one or more features of any embodiment or aspect can be combined with one or more features of any other embodiment or aspect.

## Claims

1. A potting boat assembly comprising:
a metal potting boat including a base and at least one sidewall that extends from and surrounds the base; and
an electrically insulating retaining member for retaining a circuit board within the metal potting boat,
wherein, with the electrically insulating retaining member retaining the circuit board within the metal potting boat, the circuit board is spaced apart from the base of the metal potting boat by the electrically insulating retaining member.

2. The potting boat assembly of claim 1, wherein the at least one sidewall extends between a first end that is connected to the base and a second end opposite the first end,
wherein the second end of the at least one sidewall includes at least one connecting member, and
wherein the electrically insulating retaining member includes a frame that extends within a plane of orientation and at least one complementary connecting member on the frame, wherein the at least one complementary connecting member is configured to engage with the at least one connecting member of the metal potting boat to secure the electrically insulating retaining member to the metal potting boat.

3. The potting boat assembly of claim 1 or 2, wherein the at least one connecting member includes at least one tab that extends substantially perpendicularly from the second end of the at least one sidewall of the metal potting boat, and
wherein the at least one complementary connecting member includes at least one resilient arm that extends from the frame substantially perpendicularly to the plane of orientation of the frame, wherein the at least one resilient arm extends between a first end that is connected to the frame and a second end opposite the first end, wherein the at least one resilient arm is configured to engage the at least one tab by deflecting to allow the second end of the at least one resilient arm to pass over the at least one tab and snap into engagement behind the at least one tab to secure the electrically insulating retaining member to the metal potting boat.

4. The potting boat assembly of claim 3, wherein the at least one resilient arm includes at least one opening between the first end and the second end, wherein the at least one tab is received within the at least one opening when the second end of the at least one resilient arm is snapped into engagement behind the at least one tab to secure the electrically insulating retaining member to the metal potting boat.

5. The potting boat assembly of claim 3 or 4, wherein the at least one tab extends from an outer surface of the at least one sidewall that is opposite an inner surface of the at least one sidewall that defines an interior of the metal potting boat with the base,
wherein the frame has a closed shape that corresponds to a closed shape of the at least one sidewall, and
wherein, with the at least one complementary connecting member engaged with the at least one connecting member of the metal potting boat to secure the electrically insulating retaining member to the metal potting boat, at least a portion of a lower surface of the frame is disposed on the second end of the at least one sidewall of the metal potting boat.

6. The potting boat assembly of any of claims 3 to 5, wherein the at least one tab includes one or more first tabs that extend from the outer surface of the at least one sidewall at a first location of the closed shape of the at least one sidewall and one or more second tabs that extend from the outer surface of the at least one sidewall at a second location of the closed shape of the at least one sidewall opposite the first location of the closed shape of the at least one sidewall, and
wherein the at least one resilient arm includes one or more first resilient arms that extend from the frame substantially perpendicularly to the plane of orientation of the frame at a first location of the closed shape of the frame and one or more second resilient arms that that extend from the frame substantially perpendicularly to the plane of orientation of the frame at a second location of the closed shape of the frame opposite the first location of the closed shape of the frame.

7. The potting boat assembly of any preceding claim, wherein the electrically insulating retaining member includes a frame that extends within a plane of orientation and at least one supporting member that extends from the frame substantially perpendicularly to the plane of orientation of the frame,
wherein the at least one supporting member extends between a first end that is connected to the frame and a second end opposite the first end,
wherein the second end of the at least one supporting member includes a ledge that extends substantially perpendicularly from the at least one supporting member, and
wherein, with the electrically insulating retaining member retaining the circuit board within the metal potting boat, the ledge supports the circuit board between the first and second ends of the at least one supporting member such that the circuit board is spaced apart from the base of the metal potting boat by the ledge of the at least one supporting member.

8. The potting boat assembly of any preceding claim, wherein at least one edge of the circuit board includes at least one cutout that extends inward from the at least one edge of the circuit board, and
wherein, with the electrically insulating retaining member retaining the circuit board within the metal potting boat, the at least supporting member extends through the at least one cutout in the circuit board.

9. The potting boat assembly of claim 7 or 8, wherein the frame has a closed shape that corresponds to a closed shape of the at least one sidewall, and
wherein the at least one supporting member includes one or more first supporting members that extend from the frame substantially perpendicularly to the plane of orientation of the frame at a first location of the closed shape of the frame and one or more second supporting members that that extend from the frame substantially perpendicularly to the plane of orientation of the frame at a second location of the closed shape of the frame opposite the first location of the closed shape of the frame.

10. The potting boat assembly of any of claims 2 to 9, wherein, with the electrically insulating retaining member retaining the circuit board within the metal potting boat, a potting material is disposed between the frame and the circuit board and between the circuit board and the base of the metal potting boat.

11. The potting boat assembly of any preceding claim, wherein, with the electrically insulating retaining member retaining the circuit board within the metal potting boat, at least one thermally conductive electrically insulating gap pad is disposed between and in contact with each of the circuit board and the base of the metal potting boat.

12. The potting boat assembly of any of claims 2 to 11, wherein the electrically insulating retaining member further includes at least one wire trap that extends from the frame substantially perpendicularly to the plane of orientation of the frame in a direction opposite that of the at least one supporting member.

13. The potting boat assembly of any of claims 7 to 12, wherein the at least one supporting member is heat staked to the base of the metal potting boat.

14. The potting boat assembly of any preceding claim, wherein the circuit board includes a control module for supplying electric power from a DC power source to an electric motor.

15. The potting boat assembly of claim 14, wherein the circuit board includes a first face and a second face opposite the first face,
wherein, with the electrically insulating retaining member retaining the circuit board within the metal potting boat, the second face of the circuit board faces the base of the metal potting boat, and
wherein the control module includes:
a plurality of power switch devices including a plurality of high-side power switches and a plurality of low-side power switches mounted on the first face of the circuit board and configured as a multi-phase inverter circuit to provide a plurality of output phase terminals to the electric motor;
one or more bus capacitors mounted on the first face of the circuit board; and
a microcontroller mounted on the first face of the circuit board.

16. An electric power tool comprising:
a tool housing;
an electric motor disposed in the tool housing; and
the potting boat assembly of any preceding claim disposed in the tool housing, wherein the circuit board includes a control module for supplying electric power from a DC power source to the electric motor.
